Europäisches Patentamt

European Patent Office

Office européen des brevets

(19)

(11) Publication number: **0 204 261**
**A2**

(12) # EUROPEAN PATENT APPLICATION

(21) Application number: **86107243.7**

(22) Date of filing: **28.05.86**

(51) Int. Cl.⁴: **H 01 L 23/14**
**H 01 L 21/48**

(30) Priority: **03.06.85 JP 118963/85**

(43) Date of publication of application:
**10.12.86 Bulletin 86/50**

(84) Designated Contracting States:
**DE FR GB**

(71) Applicant: **HITACHI, LTD.**
**6, Kanda Surugadai 4-chome Chiyoda-ku**
**Tokyo 100(JP)**

(72) Inventor: **Tosaki, Hiromi 406, Pairot-Hausu San-Totsuka**
**4208-10, Totsuka-cho Totsuka-ku**
**Yokohama-shi Kanagawa-ken(JP)**

(72) Inventor: **Itoh, Mitsuko**
**5-80, Uraga-cho**
**Yokosuka-shi Kanagawa-ken(JP)**

(72) Inventor: **Dokochi, Hisashi**
**403, Hitachikasei Ishigami Apt. 1344-8, Tarazaki**
**Katsuta-shi Ibaraki-ken(JP)**

(74) Representative: **Altenburg, Udo, Dipl.-Phys. et al,**
**Patent- und Rechtsanwälte**
**Bardehle-Pagenberg-Dost-Altenburg-Frohwitter &**
**Partner Postfach 86 06 20**
**D-8000 München 86(DE)**

(54) **Multilayer wiring board and method of manufacturing the same.**

(57) Disclosed are a multilayer wiring board and a method of manufacturing the same, in which circuits are multilayered using as an insulating material a sintered compact of an oxide mixture obtained by mixing a glass material powder and an inorganic oxide powder so that the inorganic oxide powder may amount to 30 - 50 wt.% of the whole powdery mixture consisting of it and the glass material powder,

the glass material powder having a composition of 20 - 30wt.% of $SiO_2$, 18 - 25 wt.% of $Al_2O_3$, 18 - 20 wt.% of $B_2O_3$, 1 - 6 wt.% of $ZnO$, 18 - 28 wt.% of $BaO$, and 1 - 8 wt.% of $MgO$ and $Cao$ in total, and having a mean particle size of 2.0 - 4.0 μm,

the inorganic oxide powder consisting of an $Al_2O_3$ powder having a mean particle size of 2.0 - 4.0 μm and a $ZrSiO_4$ powder having a mean particle size of 2.0 - 4.0 μm.

The multilayer wiring board sintered at a low temperature has a high flexural strength and a high adhesion strength of soldering.

FIG. 1

0204261

SPECIFICATION

Title of the Invention:

Multilayer Wiring Board and Method of Manufacturing the Same

Background of the Invention:

The present invention relates to a multilayer wiring board in which a mixture consisting of a glassy material powder and an inorganic oxide powder is multilayered as an insulating material, and a method of the manufacturing it. More particularly, the invention relates to a multilayer wiring board which is formed in such a way that a powdery mixture of insulating materials is employed for a green sheet and insulator paste and is multilayered by way of example, and a method of manufacturing it.

In recent years, as electronic apparatuses have been endowed with multiplicities of functions, multi-layer wiring is eagerly required of various wiring boards in order to mount IC or LSI chips. At present, alumina base multilayer wiring boards are applied as meeting the requirement. However, they invovlve the problems of high installation and process costs for such reasons (1) that the sintering temperature is as high as 1600°C, (2) that the strict atmosphere

control of $N_2$-$H_2O$-$H_2$ etc. is necessary for the prevention of the oxidation of a refractory metal such as tungsten or the burning-out of an organic polymer, and (3) that plating with, e.g., Ni-Au for soldering to a pad of, e.g., tungsten is needed. Especially, it is problematic that the manufacturing process becomes long because the period of time required for sintering extends over 20 - 30 hours.

To the end of solving the problems, a multilayer wiring board is being developed wherein a glass powder or a glass-ceramic powder which is an insulating material adapted to be sintered at or below 1000°C is used for a substrate and wherein Ag-Pd, Au-Pt or the like which can be soldered is used as a conducting material. The sintered substrate of the glass powder or the glass-ceramic powder, however, is low in the mechanical strengths represented by the flexural strength and has only the strength of 10 kg/mm$^2$ which is 1/2 -1/3 of the strength of sintered alumina substrate. This leads to the serious problem that the adhesion strength of soldered pads is low and that the sintered substrate cannot endure practical use. In this regard, for the purpose of enhancing the adhesion strength of soldered pads and further enhancing the mechanical strengths of the glass base sintered substrate, not only the composition of the substrate but also a raw material powder is made finer.  Usually the mean particle size of the raw material powder is made 1.0 µm - 1.5 µm or less, thereby to attain the flexural strength of at least 15 kg/mm$^2$ which can endure practical use.  However, when the insulating material is such fine particles, only a green sheet which is at most 0.3 mm thick can be attained by a green sheet preparation method based on a doctor blade method.

In forming a multilayer structure, therefore, a sheet lamination method is employed wherein the thin green sheet is formed with wiring by printing and wherein a plurality of such green sheets are stacked into a lamination.  This method is indispensable for forming the multilayer structure which consists of five or more layers by way of example, but it has the problem of necessity for apparatuses such as a puncher for forming through holes, a sheet alignment apparatus of high precision and a laminating apparatus.

A screen-print multilayering method which is another multilayering method forms a multilayer structure in such a way that a green sheet usually 1 mm thick is coated with a conductor paste and an insulator paste alternately by printing.  With this method, a production apparatus for the so-called thick film hybrid IC (integrated circuit) board in which a film circuit is formed on a sintered substrate by printing and firing is applicable, and a multilayer structure of up to five layers or so can be formed by a simple process. The method therefore has the merit that the process can be sharply simplified when it is compared with the sheet lamination method. For this reason, the application of the screen-print multilayering method is desired in case of forming the multilayer structure of about five layers. Since, however, the green sheet for the glass type sintered substrate having the practicable flexural strength is limited to the thickness of at most 0.3 mm as described before, the sheet 1 mm thick required for the screen-print multilayering method must be prepared. This necessitates the process that several sheets are previously stacked and then used. Besides, when a powdery paste of fine particles is printed and formed on a thick glass base green sheet formed by stacking thin sheets made of a glass material of fine particles and the green sheet is sintered integrally with a printed insulator film, there arises the problem fatal to a substrate that the sintered substrate warps greatly. Further, since the green sheet undergoes a dimensional shrinkage of 10 - 20 % at the sintering step, the problem of the appearance of the deformation, peeling and wrinkles of wiring is also left when the printed wiring is sintered simultaneously with the green sheet and the insulator film.

As described above, the base board of an insulating material for a multilayer wiring board is required to be low in the sintering temperature and high in the flexural strength. However, the compatibility is not easy.

The following references are cited to show the state of the art:

i) "A multi-layer ceramic, multi-chip module," Proceedings of the 30th Electronic Components Conference (1980), pp. 283-285,

ii) "LOW FIRING TEMPERATURE MULTILAYER GLASS-CERAMIC SUBSTRATE," IEEE (1983) pp. 314-319,

iii) Official Gazette of U.S. Patent No. 4,490,429, and

iv) Official Gazette of U.S. Patent No. 4,547,625.

Summary of the Invention:

An object of the present invention is to solve the problems of the prior arts in the preparation of a multilayer wiring board, and to provide a multilayer wiring board and a method of manufacturing it in or by which the sintering temperature of a base board of an insulating material is low, the mechanical strengths (represented by the flexural strength) of a sintered substrate are high, the deformation of a conductor etc. or the warp of the multilayer board attributed to sintering is not involved, and a multilayer structure can be formed by a simple process.

In order to accomplish the object, the multilayer wiring board of the present invention comprises an insulating substrate, at least two conductor layers of predetermined patterns which are provided on said insulating substrate, and an insulator film which is interposed between said conductor layers, said insulating substrate and said insulator film being made of an insulating material which is produced by sintering an oxide mixture of i) 70 - 50 wt.% of glass material powder having a composition of 20 - 30 wt.% of $SiO_2$, 18 - 25 wt.% of $Al_2O_3$, 18 - 20 wt.% of $B_2O_3$, 1 - 6 wt.% of ZnO, 18 - 28 wt.% of BaO, and 1 - 8 wt.% of MgO and CaO in total, and ii) 30 - 50 wt.% of inorganic oxide powder composed of $Al_2O_3$ powder and $ZrSiO_4$ powder.

In cases where the contents of the respective oxides constituting the glass material powder fall outside the specified ranges, disadvantages to be stated below arise, and any of the cases is unfavorable.

When the $SiO_2$ content is less, the flexural strength of the sintered substrate is low, and when it is more, the sintering temperature becomes high; when the $Al_2O_3$ content is less, the flexural strength of the sintered substrate is low, and when it is more, the sintering temperature becomes high; when the $B_2O_3$ content is less, sintering in a short time is impossible, and when it is more, the sintered substrate undergoes the collapse of shoulders; when the ZnO content is less, the flexural strength of the sintered substrate is low, and when it is more, the sintered substrate becomes porous due to inferior sintering; when the BaO content is less, the flexural strength of the sintered substrate is low, and when it is more, the insulation degrades; and when the total content of MgO and CaO is less, the sintered substrate becomes porous due to inferior sintering, and when it is more, the sintered substrate cracks. In the above, the expression "the flexural strength is low" singnifies that it is less than 15 $kg/mm^2$, and the expression "the sintering temperature is high" signifies that it exceeds 900°C.

When the proportion of the glass material powder in the oxide mixture is less than 50 wt.%, unpreferably a green sheet cannot be densely sintered and the sintered body becomes porous, and both the moisture resistance between the layers and the withstand voltage between the layers are low. In the worst case, the adjacent wiring layers might short-circuit. Further, when the proportion of the glass material powder in the oxide mixture exceeds 70 wt.%, the sintered compact of the green sheet undergoes collapse, and the patterns of printed wiring etc. undergo deformations ascribable to the flow of glass, so that such a proportion is also unpreferable.

CaO and MgO constituting the glass material powder may amount to 1 - 8 wt.% in total, and the mixing ratio of the two is not limited. Only CaO or only MgO may well be contained.

In a preferable aspect of performance of the present invention, the inorganic oxide powder employed is such that $Al_2O_3$ falls within a range of 0.4 - 0.7 of the whole mixture consisting of $Al_2O_3$ and $ZrSiO_4$ by the weight ratio. With the mixture in this range, Ag-Pd pads which are sintered and formed simultaneously with the green sheet exhibit a high adhesion strength of soldering.

The mean particle size of the glass material powder and the mean particle sizes of the $Al_2O_3$ powder and $ZrSiO_4$ powder constituting the inorganic oxide powder are all 2.0 - 4.0 µm.

The reasons why the mean particle sizes of the glass material powder and the inorganic oxide powder are set at 2.0 - 4.0 µm in the present invention are that, when the mean particle size of the starting material mixture is smaller than 2.0 µm, the green sheet sometimes cracks at a drying step in the preparation of the green sheet, and that, when it is greater than 4.0 µm, the rough surface of the green sheet worsens the smoothness of the surface of an Ag-Pd pad film.

Each of the conductor layers of predetermined patterns is made of a conducting material produced by sintering a metal powder mixture of 80 - 75 wt.% of Ag powder and 20 - 25 wt.% of Pd powder. The mean particle size of the Ag powder is set at 0.3 - 0.7 µm, and that of the Pd powder at 0.2 - 0.5 µm. By setting the particle sizes of the Ag powder and Pd powder of the starting material within the above ranges and setting the composition ratio of Ag-Pd within the above range, the adhesion strength of the soldered pads could be rendered sufficient and the smoothness of the surfaces of the conductor layers could be rendered good.

The multilayer wiring board of the present invention is manufactured in such a way that a green sheet having a thickness of, e.g., 1.0 ± 0.2 mm and also an insulator paste for printing are prepared from the oxide mixture described above, that a conductor paste for printing conductor layers is prepared from the metal powder mixture described above, that the conductor paste and the insulator paste of predetermined patterns are alternately and repeatedly printed on the green sheet so as to prepare a multilayer structure, and that the multilayer structure is sintered by heating it at the highest temperature of 800 - 900°C for 5 - 30 minutes.

The green sheet is obtained in such a way that the oxide mixture has a binder, a plasticizer and a solvent added thereto, is kneaded and then degassed to prepare a slurry, and that the slurry is put into the form of a sheet of predetermined thickness and then dried. The insulator paste is obtained by adding a binder and a solvent to the oxide mixture and kneading the oxide mixture, while the conductor paste is obtained by adding a binder and a solvent to the metal powder mixture. These methods of preparing the green sheet, the insulator paste and the conductor paste are well known except that the compositions and mean particle sizes of the oxide mixture and metal

0204261

powder mixture are peculiar to the present invention.

Here, the conductor paths of the upper and lower wiring layers can be formed in such a way that, in forming the insulator film, the corresponding parts are formed as through holes which are not printed and not coated with the insulator paste, whereupon they are printed and filled up with the conductor paste.

Using the multilayer wiring board the manufacturing method according to the present invention as thus far described, in the first place, a green sheet 1.0 mm thick can be prepared, and the flexural strength of the sintered compact of this material can be rendered as high as at least 15 $kg/mm^2$. In the second place, a base board in which printed wiring is multilayered on the green sheet with a printed insulator film used for inter-layer insulation does not undergo a warp due to sintering. In the third place, a printed conductor is free from peeling or deformation, and the adhesion strength of soldered pads can be rendered at least 1.5 $kg/mm^2$.

In this manner, a favorable multilayer structure can be formed owing to the combination of the materials described above.

Brief Description of the Drawings:

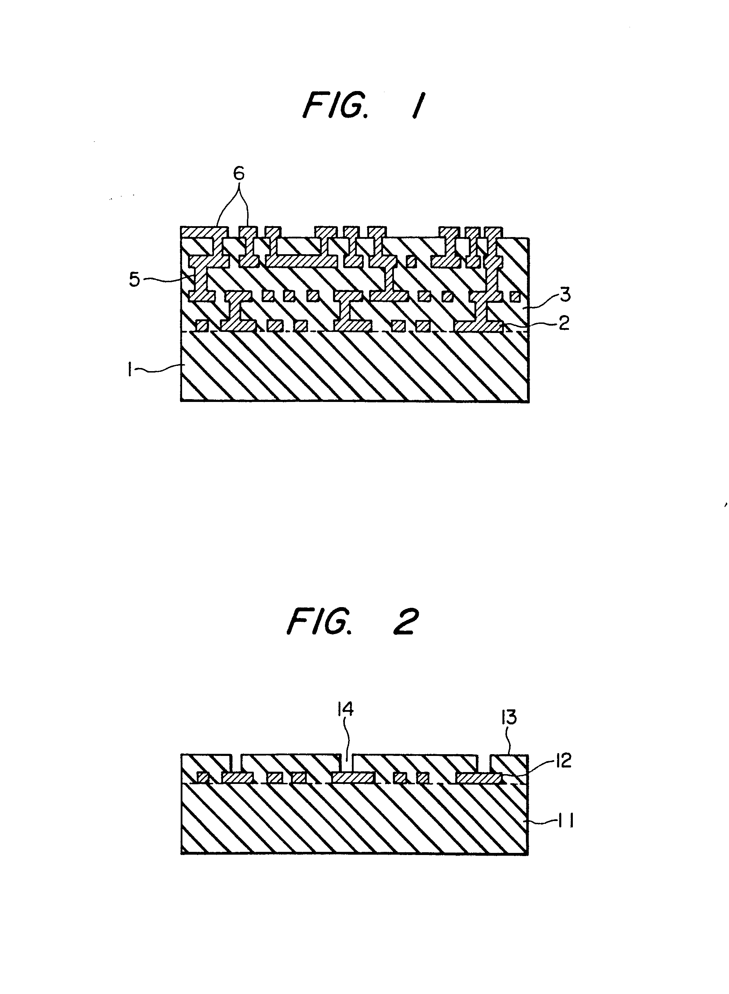

Fig. 1 is a sectional view of a multilayer wiring board in an embodiment of the present invention, while Fig. 2 is a sectional view for explaining a multilayering step in an embodiment of the present invention.

Description of the Preferred Embodiments:

As shown in Fig. 1, a multilayer wiring board produced by an embodiment is such that an insulating substrate 1 obtained by sintering a green sheet of a glass base insulating material and inter-wiring insulator films 3 constitute a base board in which wiring leads 2 are formed, and that the wiring leads 2 are vertically connected by a conductor which is formed in vias (conductor paths) 5. Numerals 6 designate component connecting pads, to which a packaged IC, input/output terminal pins, etc. are connected.

The insulating material used in this embodiment was a mixture consisting of a glass material, an $Al_2O_3$ powder and a $ZrSiO_4$ powder. The glass material consisted of $SiO_2$, $Al_2O_3$, $B_2O_3$, ZnO, BaO, MgO and Cao, and the compositions thereof are listed in Table 1. The mean particle size of the glass powder was controlled to 2.0 - 0.4 μm. Also the $Al_2O_3$ powder and the $ZrSiO_4$ powder being inorganic oxides had mean particle sizes within the range of 2.0 - 4.0 μm, and the $Al_2O_3$ powder fell within a range of 0.4 - 0.7

0204261

as indicated in Table 2 with respect to the total weight between it and the $ZrSiO_4$ powder.

As referred to above, Table 1 lists the compositions of the glass materials used in the present embodiment, and Table 2 lists the compositions of the inorganic oxide powders used in the present embodiment, as well as the particle sizes of the starting materials.

Table 1

| Materials | Material Nos. of Glass Materials | | | | | | | | | |
|---|---|---|---|---|---|---|---|---|---|---|
| | 1 | 2 | 3 | 4 | 5 | 6 | 7 | 8 | 9 | 10 |
| $SiO_2$ | 20 | 20 | 24 | 25 | 26 | 27 | 28 | 30 | 30 | 30 |
| $Al_2O_3$ | 25 | 25 | 24 | 25 | 18 | 22 | 25 | 25 | 18 | 18 |
| $B_2O_3$ | 20 | 20 | 20 | 18 | 17 | 18 | 20 | 18 | 20 | 18 |
| $BaO$ | 21 | 28 | 26 | 25 | 28 | 23 | 18 | 19 | 25 | 20 |
| $ZnO$ | 6 | 3 | 2 | 3 | 5 | 5 | 3 | 4 | 3 | 6 |
| $MgO$ | 4 | 2 | 2 | 2 | 2 | 2 | 4 | 2 | 2 | 4 |
| $CaO$ | 4 | 2 | 2 | 2 | 4 | 3 | 2 | 2 | 2 | 4 |

Table 2

| Starting Materials | Proportions and Particle Sizes | Material Nos. of Inorganic Oxide Powders | | | | | | | | | | | | | | | |
|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 16 |
| $Al_2O_3$ Powder | Proportions (%) | 40 | | | | 50 | | | | 60 | | | | 70 | | | |
| | Particle sizes (µm) | 2 | 2 | 4 | 4 | 2 | 2 | 4 | 4 | 2 | 2 | 4 | 4 | 2 | 2 | 4 | 4 |
| $ZrSiO_4$ Powder | Proportions (%) | 60 | | | | 50 | | | | 40 | | | | 30 | | | |
| | Particle Sizes (µm) | 2 | 4 | 2 | 4 | 2 | 4 | 2 | 4 | 2 | 4 | 2 | 4 | 2 | 4 | 2 | 4 |
| $Al_2O_3$ / $(Al_2O_3 + ZrSiO_4)$ ratio | | 0.4 | | | | 0.5 | | | | 0.6 | | | | 0.7 | | | |

The mean particle size of the oxide mixture was set at 2.0 - 4.0 µm. Owing to this range, the green sheet was prevented from cracking at a drying step in the preparation of the green sheet, and the surface of the green sheet could be smoothed, so that the smoothness of the surface of the Ag-Pd terminal film could be held good. In addition, the insulating material of the present embodiment was such that the inorganic oxide powder was set at a mixing ratio of 30 - 50 wt.% of the whole oxide mixture consisting it and the glass material, whereby the collapsing of the sintered compact of the green sheet and the deformation of the patterns of the printed wiring etc. were prevented and the green sheet could be densely sintered, so that the moisture resistance and withstand voltage between the stacked layers could be rendered good.

In the present embodiment, there was used the inorganic oxide powder in which $Al_2O_3$ fell within a range of 0.4 - 0.7 of the whole mixture consisting of $Al_2O_3$ and $ZrSiO_4$ by the weight ratio. With the mixture in this range, the Ag-Pd pads sintered and formed simultaneously with the green sheet exhibited a high adhesion strength of soldering. Table 3 concretely indicates the compositions of the oxide mixtures of the prepared insulating materials, the mean particle sizes of the starting materials, and the mean particle sizes of the oxide mixtures obtained.

Table 3

| Starting Materials | Compositions, Particle Sizes and Proportions | Material Nos. of Oxide Mixtures | | | | | | | | | | | | | | | | | | |
|---|---|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 16 | 17 | 18 | 19 |
| Glass Materials | Mat. Nos. of Table 1 | 1 | 1 | 1 | 2 | 3 | 4 | 5 | 6 | 6 | 6 | 7 | 7 | 8 | 8 | 9 | 9 | 10 | 10 | 10 |
| | Mean Particle Sizes (µm) | 2.0 | 3.0 | 1.0 | 1.0 | 2.0 | 3.0 | 1.0 | 2.0 | 3.0 | 2.0 | 1.0 | 1.0 | 2.0 | 3.0 | 1.0 | 1.0 | 2.0 | 2.0 | 1.0 |
| | Proportions (wt.%) | 70 | 60 | 50 | 60 | 60 | 60 | 60 | 70 | 60 | 50 | 70 | 50 | 70 | 50 | 70 | 50 | 70 | 60 | 50 |
| Inorganic Oxide Powders | Mat. Nos. of Table 2 | 1 | 1 | 2 | 3 | 4 | 5 | 6 | 7 | 8 | 9 | 10 | 10 | 11 | 12 | 13 | 14 | 15 | 16 | 16 |
| | Proportions (wt.%) | 30 | 40 | 50 | 40 | 40 | 40 | 40 | 30 | 40 | 50 | 30 | 50 | 30 | 50 | 30 | 50 | 70 | 40 | 50 |
| Mean Particle Size of Oxide Mixture (µm) | | 2.0 | 3.1 | 3.6 | 3.5 | 2.8 | 2.6 | 3.6 | 2.3 | 3.4 | 2.0 | 3.6 | 3.4 | 2.4 | 3.5 | 3.4 | 3.3 | 2.4 | 2.8 | 1.0 |

In the present embodiment, the oxide mixture consisting of the glass material and the inorganic oxides could be sintered at 800 - 900°C. The sintering at the above temperatures was permitted by the use of the glass powder for the oxide mixture. As compared with the prior-art alumina base multilayer wiring board whose sintering temperature was 1600°C, the invention could sharply lower the temperature. In consequence, the invention dispensed with apparatuses and processes required for the strict atmosphere control of $N_2$-$H_2O$-$H_2$ etc. for the prevention of the oxidation of a refractory metal such as tungsten and the burning-out of organic polymers and could shorten the manufacturing process.

For the same reason, in the present embodiment, a green multilayer wiring board in which the oxide mixture to serve as the insulating material and the metal powder mixture to serve as the conducting material were combined was permitted to be unitarily sintered at 800 - 900°C. Therefore, a warp ascribable to the sintering and the peeling and deformation of the printed conductor were not involved, and the manufacturing process could be shortened.

Further, the metal powder mixture used with the oxide mixture in the present embodiment consisted of 80 - 75 wt.% of Ag powder having a mean particle size of 0.3 - 0.7 μm and 20 - 25 wt.% of Pd powder having a mean particle size of 0.2 - 0.5 μm, which were mixed. With the particle sizes and the composition proportions in the specified ranges, the adhesion strength of the soldered pads could be enhanced, and the smoothness of the film surface could be rendered good. Concretely, the proportions and particle sizes of the starting materials of the metal powder mixtures performed are as listed in Table 4.

Table 4

| Starting Materials | Proportions and Particle Sizes | Material Nos. of Metal Powder Mixtures | | | | | | | | | | | | | | | | | |
|---|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 16 | 17 | 18 |
| Ag Powder | Proportions (wt.%) | 80 | | | | | | 77.5 | | | | | | 75.0 | | | | | |
| | Particle Sizes (µm) | 0.3 | | 0.5 | | 0.7 | | 0.3 | | 0.5 | | 0.7 | | 0.3 | | 0.5 | | 0.7 | |
| Pd Powder | Proportions (wt.%) | 20 | | | | | | 22.5 | | | | | | 25.0 | | | | | |
| | Particle Sizes (µm) | 0.2 | 0.5 | 0.2 | 0.5 | 0.2 | 0.5 | 0.2 | 0.5 | 0.2 | 0.5 | 0.2 | 0.5 | 0.2 | 0.5 | 0.2 | 0.5 | 0.2 | 0.5 |

Next, a method of manufacturing the multilayer wiring board of the present embodiment will be described. This multilayer wiring board was produced by the following steps I - VI:

Step I: Preparation of Glass Material Powder

$SiO_2$, $Al_2O_3$, $B_2O_3$, ZnO, BaO, MgO and CaO were weighed as carbonates or oxides so as to conform to each of the compositions in Table 1 and were mixed, whereupon the mixture was thrown into a platinum beaker and was melted at 1400°C. The melt was quenched, and the resulting material was pulverized into a glass material powder having a mean particle size of 2.0 - 4.0 μm.

Step II: Preparation of Green Sheet

Each of the inorganic oxide powders which were the mixtures consisting of the $Al_2O_3$ powder and the $ZrSiO_4$ powder listed in Table 2 was weighed and mixed into the glass material powder prepared by the step I, to prepare the oxide mixture as indicated in Table 3. Further, a binder (for example, polyvinyl butyral), a plasticizer and a volatile solvent were added to the powder particles, and the powdery mixture was kneaded and then degassed to prepare a slurry. Subsequently, the slurry was applied onto a polyester film by the well-known doctor blade method and was dried to prepare a green sheet 1.0 mm thick. The sheet was punched into a square each side of which was 12 cm, to form a green sheet shown at 11 in Fig. 2 as a substrate for printing.

The slurry for the green sheet in the present embodiment was prepared in such a way that a) the oxide mixture consisting of the glass material powder and the inorganic oxide powder and amounting to 1 kg, b) the binder made of polyvinyl butyral and amounting to 60 gr, c) the plasticizer made of butyl phthalyl butyl glycolate and amounting to 30 cc, and d) the volatile solvent made of 60 vol.% of trichloroethylene, 23 vol.% of tetrachloroethylene and 17 vol.% of butyl alcohol and amounting to 500 cc were kneaded, whereupon the kneaded material was degassed.

Step III: Preparation of Insulator Paste

50 cc of vehicle in which a polymer such as ethyl cellulose was dissolved in a volatile solvent was added to 100 gr of powder having the same composition and the same particle size distribution as those of the oxide mixture used for the preparation of the green sheet, and the powder was kneaded to prepare a paste for forming a printed insulator film.

The vehicle was such that 30 gr of ethyl cellulose and 20 gr of polyvinyl butyral resin were dissolved in 500 cc of α-terpineol.

Step IV: Preparation of Conductor Paste

40 cc of vehicle in which ethyl cellulose and polyvinyl butyral were dissolved in an alcoholic solvent was added to 100 gr of metal powder mixture which was the conducting powder of each of the compositions listed in Table 4, to prepare a conductor paste.

The vehicle had the same composition as that of the foregoing vehicle used at the step III.

Step V: Multilayering Step

This step will be described with reference to Fig. 2.

Using the ordinary thick film printing technology, wiring was multilayered on the green sheet 11. More specifically, the conductor paste prepared by the step IV was printed through a screen mask for the wiring pattern of the lowermost layer, to form the lowermost wiring conductor paste layer 12 on the green sheet. Subsequently, the insulator paste prepared by the step III was printed through a screen mask for an insulator layer, except connection parts for an upper layer circuit, whereby an insulator paste layer 13 for an insulator film was formed. At this time, the connection parts of the lowermost layer for connecting the lowermost layer and the upper layer circuit were

- 23 -

0204261

opened as through holes 14. Therefore, the through holes 14 were printed and filled up with the prepared conductor paste into vias (conductor paths) 5. Further, the upper layer circuit was printed and formed as the lowermost layer. To the uppermost layer, a conductor paste layer to serve as component connecting pads 6 in Fig. 1 was formed.

Though not shown in the present embodiment, a construction can also be adopted wherein wiring is formed together with the pads as the uppermost layer circuit and wherein an insulator film is formed on the wiring parts except the pad parts.

Step VI: Sintering

The multilayer structure having completed the step V, in which the wiring was multilayered on the green sheet by the printing method, was sintered in the air by a thick film belt furnace having a temperature profile in which 800 - 900°C was held for 10 minutes. Fig. 1 shows the multilayer wiring board thus obtained.

Components such as packaged ICs, ceramic chip capacitors and input/output clip leads could be connected with the pads 6 on the multilayer wiring board produced by the present embodiment, by the use of a Pb/Sn eutectic solder.

The multilayer wiring board of the present embodiment is formed via the steps I - VI as described above.

Next, Table 5 indicates examples of the combinations of the materials used in the present embodiment and also indicates the characteristics of the green sheets prepared according to the above steps. In Table 5, the compositions of the oxide mixture to serve as the insulating material are denoted by Nos. of the compositions in Table 3. Likewise, the compositions of the metal powder mixture to serve as the conducting material are denoted by Nos. in Table 4. Mentioned as the characterstics are (1) the situation of cracks in the green sheet 1.0 mm thick, (2) the warp of the sintered multilayer structure, (3) the flexural strength of the sintered multilayer structure, (4) the peeling strength of the soldered pad in the shape of a square each side being 2 mm long, and (5) the smoothness, deformation etc. of the conductor.

Table 5

| | Examples | | | | | | | | | | | | |
|---|---|---|---|---|---|---|---|---|---|---|---|---|---|
| | 1 | 2 | 3 | 4 | 5 | 6 | 7 | 8 | 9 | 10 | 11 | 12 | 13 |
| Material Nos. of Table 3 | 1 | 2 | 3 | 4 | 5 | 8 | 9 | 10 | 11 | 13 | 17 | 18 | 19 |
| Material Nos. of Table 4 | 1 | 3 | 4 | 6 | 7 | 8 | 9 | 10 | 11 | 13 | 14 | 16 | 18 |
| Cracks of Green Sheets 1.0 mm thick due to Drying | None | None | None | None | None | None | None | None | None | None | None | None | None |
| Warps of Multilayer Sintered Compacts | None | None | None | None | None | None | None | None | None | None | None | None | None |
| Flexural Strengths of Insulating Materials $(kg/mm^2)$ | 21.0 | 19.3 | 15.5 | 16.2 | 20.5 | 22.5 | 17.3 | 19.7 | 15.1 | 19.7 | 19.3 | 20.7 | 16.3 |
| Peeling Strengths of Soldered Pads $(kg/mm^2)$ | 2.0 | 1.8 | 1.6 | 1.5 | 2.0 | 2.2 | 1.8 | 2.0 | 1.5 | 1.6 | 1.7 | 1.9 | 1.5 |
| Deformations etc. of Conductors | None | None | None | None | None | None | None | None | None | None | None | None | None |

As apparent from Table 5, in the green sheets of the insulating materials and the multilayer wiring boards formed in accordance with the present embodiment,

(1) the green sheet 1.0 mm thick does not crack due to drying,

(2) the substrate in which the wiring is printed on the green sheet and multilayered through the insulator film does not warp,

(3) the flexural strength of the sintered insulating material is at least 15 kg/mm$^2$ and is higher than that of the prior-art glass substrate, and

(4) the peeling strength of the pad is at least 1.5 kg/mm$^2$, and an adhesion strength effective for practical use is attained.  Further,

(5) the conductor film which was printed on the green sheet of the insulating material and on the insulator paste for the insulator film, formed by printing and which was sintered unitarily with the green material for the insulation did not undergo peeling, deformation, wrinkles etc. and was favorable.

As to combinations not included in the present invention, (1) when the composition and particle size of the oxide mixture fall outside the ranges of the present invention, a thick green sheet cannot be favorably formed, and the strength of a sintered insulating material is low, so that a warp appears in the unitary sintered compact of a green sheet and an insulator film formed by printing. (2) When the composition and particle size of the metal powder mixture to serve as the conducting material fall outisde the ranges of the present invention, a conductor film obtained by sintering undergoes peeling, deformation or/and wrinkles and affords a low adhesion strength of soldered pads. In addition, favorable results could be similarly obtained with the combinations of the materials listed in Tables 1 - 4 other than those of Table 5.

The above embodiments exemplify the present invention, but it is a matter of course that the present invention is not restricted only to these embodiments.

As thus far described, according to the present invention, the problems of the prior arts in the preparation of a multilayer wiring board are solved. While the sintering temperature of a green material to serve as an insulating material is suppressed low, the mechanical strengths of a sintered substrate can be maintained high, so that a green sheet which provides a sintered insulating material having a high flexural strength can be prepared. Besides, in the unitary sintering of the green sheet and an insulator paste for an insulator film formed by printing, a warp does not appear, and a smooth conductor film exhibiting a high adhesion strength of soldered pads can be formed. Moreover, owing to the use of a simple printing method, a multilayer wiring board can be formed by a simple process.

CLAIMS

1. A multilayer wiring board comprising an insulating substrate, at least two conductor layers of predetermined patterns which are provided on said insulating substrate, and an insulator film which is interposed between said conductor layers, said insulating substrate and said insulator film being made of an insulating material which is produced by sintering an oxide mixture of

i) 70 - 50 wt.% of glass material powder having a composition of 20 - 30 wt.% of $SiO_2$, 18 - 25 wt.% of $Al_2O_3$, 18 - 20 wt.% of $B_2O_3$, 1 - 6 wt.% of ZnO, 18 - 28 wt.% of BaO, and 1 - 8 wt.% of MgO and CaO in total, and ii) 30 - 50 wt.% of inorganic oxide powder composed of $Al_2O_3$ powder and $ZrSiO_4$ powder.

2. A multilayer wiring board according to Claim 1, wherein a mean particle size of said glass material powder, a mean particle size of said $Al_2O_3$ powder constituting said inorganic oxide powder, and a mean particle size of said $ZrSiO_4$ powder constituting said inorganic oxide powder are all 2.0 - 4.0 µm.

3. A multilayer wiring board according to Claim 2, wherein said inorganic oxide powder is such that said $Al_2O_3$ powder falls within a range of 0.4 - 0.7 of the whole mixture consisting of said $Al_2O_3$ powder and

said $ZrSiO_4$ powder, by a weight ratio.

4.   A multilayer wiring board according to Claim 3, wherein said insulating material is such that said oxide mixture consisting of said glass material powder and said inorganic oxide powder has been sintered at 800 - 900 °C.

5.   A multilayer wiring board according to Claim 1, wherein said conductor layers are made of a conducting material which is obtained by sintering a metal powder mixture of 80 - 75 wt.% of Ag powder and 20 - 25 wt.% of Pd powder.

6.   A multilayer wiring board according to Claim 5, wherein a mean particle size of said Ag powder is 0.3 - 0.7 µm, and a mean particle size of said Pd powder is 0.2 - 0.5 µm.

7.   A multilayer wiring board according to Claim 3, wherein said conductor layers are made of a conducting material which is obtained by sintering a metal powder mixture of 80 - 75 wt.% of Ag powder and 20 - 25 wt.% of Pd powder.

8.   A multilayer wiring board according to Claim 7, wherein a mean particle size of said Ag powder is 0.3 - 0.7 µm, and a mean particle size of said Pd powder is 0.2 - 0.5 µm.

9.   A multilayer wiring board according to Claim 8, wherein a multilayer structure in which said oxide mixture to become said insulating substrate and said insulator film is combined with said metal powder mixture to become said conductor layers is unitarily sintered at 800 - 900 °C.

10. A method of manufacturing a multilayer wiring board comprising:

i) the step of mixing 70 - 50 wt.% of glass material powder and 30 - 50 wt.% of inorganic oxide powder to prepare an oxide mixture,

said glass material powder having a composition of 20 - 30 wt.% of $SiO_2$, 18 - 25 wt.% of $Al_2O_3$, 18 - 20 wt.% of $B_2O_3$, 1 - 6 wt.% of ZnO, 18 - 28 wt.% of BaO, and 1 - 8 wt.% of MgO and Cao in total, and having a mean particle size of 2.0 - 4.0 μm,

said inorganic oxide powder consisting essentially of an $Al_2O_3$ powder having a mean particle size of 2.0 - 4.0 μm and a $ZrSiO_4$ powder having a mean particle size of 2.0 - 4.0 μm,

ii) the step of mixing a polymer, a volatile solvent and a plasticizer into said oxide mixture, to form a slurry and drying said slurry to form a flat green sheet,

iii) the step of mixing a polymer and a volatile solvent into said oxide mixture, to produce an insulator paste,

iv) the step of mixing a polymer and a volatile solvent into a metal powder mixture, to produce a conductor paste,

said metal powder mixture consisting essentially of 80 - 75 wt.% of Ag powder having a mean particle size of 0.3 - 0.7 μm and 20 - 25 wt.% of Pd powder having a mean particle size of 0.2 - 0.5 μm, and

v) the step of alternately printing said conductor paste and said insulator paste on said green sheet in multilayered fashion, and thereafter sintering the multilayer structure unitarily at 800 - 900 °C.

11. A method of manufacturing a multilayer wiring board according to Claim 10, wherein at said step v), the insulator layer to be printed has through holes in its parts to become conductor paths between the upper and lower wiring layers, and said through holes are filled up with said conductor paste when this conductor paste is printed.

FIG. 1

FIG. 2